Europäisches Patentamt

European Patent Office

Office européen des brevets

(19)

(11) Veröffentlichungsnummer: **0 032 726**
**B1**

(12) **EUROPÄISCHE PATENTSCHRIFT**

(45) Veröffentlichungstag der Patentschrift:
10.07.85

(51) Int. Cl.⁴: **H 03 K 17/97**, G 01 V 3/08

(21) Anmeldenummer: 81100272.4

(22) Anmeldetag: 15.01.81

(54) Magnetschranke.

(30) Priorität: 18.01.80 DE 3001820

(43) Veröffentlichungstag der Anmeldung:
29.07.81 Patentblatt 81/30

(45) Bekanntmachung des Hinweises auf die Patenterteilung:
10.07.85 Patentblatt 85/28

(84) Benannte Vertragsstaaten:
FR GB IT

(56) Entgegenhaltungen:
DE - A - 2 833 630
FR - A - 2 438 345
US - A - 4 156 820

BAUTEILE REPORT, Band 15, Nr. 4, August 1977,
MÜNCHEN (DE), H. EICHINGER:
"Gabel-Magnetschranke mit Hall-IS SAS250 für weiten
Temperaturbereich (-40 bis +125 Grad C)", Seiten
140-142
IEEE VEHICULAR TECHNOLOGY CONFERENCE,
Arlington Heights, Illinois, 27-30. März 1979, NEW YORK
(US), M.J. THORN: "A monolithic linear hall effect
integrated circuit", Seiten 226-229
IBM JOURNAL OF RESEARCH AND DEVELOPMENT,
Band 19, Nr. 4, Juli 1975, NEW YORK (US), R.J. BRAUN:
"Modular hall masterslice transducer", Seiten 344-352
(73) Patentinhaber: Siemens Aktiengesellschaft, Berlin und
München Wittelsbacherplatz 2, D-8000 München 2 (DE)

(72) Erfinder: Ertl, Wilhelm, Sudetenstrasse 25,
D-8012 Ottobrunn (DE)
Erfinder: Lachmann, Ulrich, Isartalstrasse 81,
D-8000 München 70 (DE)
Erfinder: Pertsch, Heinrich, Franziskanerstrasse 16,
D-8000 München 80 (DE)
Erfinder: Wirnharter, Günter, Frundsbergstrasse 7,
D-8204 Brannenburg (DE)

**Beschreibung**

Die Erfindung betrifft eine Magnetschranke mit einem Magneten und einem Halbleiterchip, das eine auf das vom Magneten ausgehende Magnetfeld reagierende integrierte Schaltung enthält, bei dem der Magnet und das Halbleiterchip gemeinsam in einem Gehäuse untergebracht sind, das mit einer sich zwischen dem Halbleiterchip und dem Magneten erstreckenden und der temporären Unterbrechung des Magnetfeldflusses zum Halbleiterchip durch externe Mittel dienenden spaltartigen Ausnehmung versehen ist, an deren dem Halbleiterchip gegenüberliegenden Seite der mit einer ebenen Oberfläche versehene eine Pol des Magneten angeordnet ist, während der andere Pol des Magneten an ein der externen Überbrückung des Magnetfelds auf dem Weg über das Halbleiterchip dienendes Magnetleitblech angrenzt.

Magnetschranken der vorgenannten gattungsgemäßen Art sind z. B. in »Siemens Bauteile Report«, 15 (1977), Heft 4, Seiten 140 bis 142 und in der US-Patentschrift 4 156 820 beschrieben.

Es wurde bereits versucht, Magnetschranken der obengenannten Art so herzustellen, daß ein mit einer integrierten Schaltung versehenes Siliciumchip mit Hilfe der sogenannten Flip-Chip-Technologie, und zwar mittels weicher Bumps auf eine Keramiksubstratplatte aufgebracht und mit einem Deckel abgedeckt wird. Auf der Keramiksubstratplatte werden Leitbahnen angebracht, die einerseits zu den Bumps des Siliciumchips führen und die an den Rändern des Keramiksubstrates mit angelöteten Anschlußdrähten versehen sind. Ein Magnet und das Siliciumchip werden in ein vorgefertigtes Gehäuse so eingebracht, daß ein ebenes Flächenteil eines Magnetpols parallel zu den beiden größten Oberflächenteilen des Siliciumchips verläuft und daß das Siliciumchip sich auf gleicher Höhe mit dem parallel verlaufenden Magnetpolflächenteil befindet. Außerdem wird in das vorgefertigte Gehäuse ein Magnetflußblech eingeführt, das dem Deckel des Siliciumchips gegenüberliegt und an diesem mit einer Erhöhung versehen ist. Der verwendete Magnet besteht aus Alnico.

Das verwendete Gehäuse weist seitliche Schlitze parallel zur Keramiksubstratplatte auf. Diese Schlitze müssen bei einem anschließenden Plastikverguß zuvor abgedeckt werden, was technische Schwierigkeiten bereitet und einen zusätzlichen Arbeitsaufwand erfordert.

Die Verwendung einer Keramikplatte, die eine Teilfläche der Gehäuseaußenwand bildet und mittels Plastikverguß mit dem übrigen Gehäuse verbunden ist, bildet in den Anschlußfugen wegen unterschiedlicher thermischer Ausdehnungskoeffizienten der verwendeten Materialien häufig Ritze, weshalb derartige Magnetschranken keinen sicheren Korrosionsschutz bieten.

Schließlich führt die Verwendung einer Keramikplatte von 0,6 mm Stärke in der eben beschriebenen Art zu einer relativ großen Spaltbreite, was eine Verschlechterung des Magnetkreises bewirkt.

Magnetschranken der beschriebenen Art weisen eine Reihe von Nachteilen auf. Sie verfügen über eine geringe mechanische Festigkeit. Außerdem ist eine Lageunsicherheit von Keramiksubstrat, d. h. auch von Siliciumchip gegenüber der Lage des Magneten und des Magnetleitblechs gegeben. Daraus resultiert wiederum eine fehlerhafte Schwankung des Magnetflusses, der das Siliciumchip durchsetzt, was eine fehlerhafte Funktion der Magnetschranke bewirkt. Durch den beschriebenen Aufbau ist der Spalt zwischen Magnetpol einerseits und Siliciumchip andererseits groß, er beträgt etwa 3 mm, andererseits ist auch der Spalt zwischen Siliciumchip und Magnetleitblech groß, er beträgt ca. 0,8 mm. Diese großen Spaltbreiten bewirken einen geringen Magnetfluß. Zur Erzielung eines gewissen ausreichenden Magnetflusses, insbesondere im Hinblick auf die Verwendung von Alnico-Magneten, muß der verwendete Magnet entsprechend groß sein. Große Spaltbreiten und große Magnete bewirken wiederum eine gewisse Mindestgröße hiernach gefertigter Magnetschranken. In gewissen Anwendungsbereichen sind jedoch große Magnetschranken nur unter Hinnahme von Nachteilen oder gar nicht anwendbar.

Weiterhin bedingt die Verwendung eines Keramiksubstrates, abgesehen von einer geringen Stoß- und Bruchsicherheit, Nachteile im Herstellungsverfahren. Der Arbeitsaufwand bei der Verwendung von Keramiksubstraten ist erheblich. Vor allem dürfte die Verwendung von Keramiksubstraten eine Automatisierung des Herstellungsverfahrens hiernach gefertigter Magnetschranken praktisch unmöglich machen. Dazu kommt, daß bei Verwendung von Alnico-Magneten die magnetische Feldstärke über längere Zeiträume nicht konstant ist, so daß hiernach gefertigte Magnetschranken nach einer gewissen Zeit funktionsuntüchtig sind.

Aufgabe der vorliegenden Erfindung ist es, eine Magnetschranke anzugeben, die zugleich kleine Abmessungen aufweist, als auch über eine hohe mechanische Robustheit sowie über eine zeitlich konstante hohe Funktionssicherheit verfügt.

Diese Aufgabe wird bei einer Magnetschranke der eingangs genannten Art erfindungsgemäß dadurch gelöst, daß das den an seinem dem Halbleiterchip zugewandten Ende mit einem ebenen Oberflächenteil versehenen Magneten tragende Magnetleitblech aus zwei Teilen besteht, wobei der mit dem Magneten verbundene Teil sich auf der einen Seite und der zweite Teil sich auf der anderen Seite der spaltartigen Ausnehmung befindet, daß dabei das Halbleiterchip in einer Aussparung eines — z. B. aus einem Kunststoffband bestehenden — Zwischenträgers auf einem in die Aussparung hineinragenden Teil des zweiten Teils des Magnetleitblechs aufliegt und seine elektrischen Anschlüsse mittels fingerartiger Kontaktstrukturen mit auf dem Zwischenträger vorgesehenen elektrischen Anschlüssen verbunden sind, daß außerdem der Zwischenträger seinerseits von einer aus isolierendem Material bestehenden Trägerplatte gehaltert ist, die mit dem externen Anschluß der auf dem Zwischenträger vorgesehenen elektrischen Anschlüssen vermittelnden leitenden Verbindungen versehen ist und daß schließlich der Gehäuseinnenraum mit einer isolierenden Vergußmasse ausgegossen ist.

Durch das Aufbringen des Halbleiterchips auf ein zugehöriges Magnetleitblech läßt sich eine Minimalisierung des Spaltes zwischen Halbleiterchip und gegenüberliegendem Magnetpol sowie zwischen Halbleiterchip und Magnetleitblech erreichen. Eine Minimalisierung des Spaltes bewirkt wiederum bei vorgegebenem Magnetfluß eine entsprechende Minimalisierung des verwendeten Magneten und führt somit zu einer Minimalisierung hiernach gefertigter Magnetschranken.

In Weiterbildung der Erfindung ist der Magnet ein Samarium-Kobalt-Magnet. Samarium-Kobalt-Magnete weisen größere und zeitlich konstante magnetische Feldstärken auf als die üblicherweise verwendeten Magneten gleicher Größe, z. B. bestehend aus Alnico oder anderen ferromagnetischen Materialien. Dadurch läßt sich in vorteilhafter Weise eine weitere Miniaturisierung und Qualitätsverbesserung hiernach gefertigter Magnetschranken erreichen.

In weiterer Ausgestaltung der Erfindung ist es zweckmäßig, daß der durch die spaltartige Ausnehmung zwischen dem Halbleiterchip und dem ihm zugewandten ebenen Oberflächenteil des Magneten bedingte Abstand auf 1 mm bis 4 mm, insbesondere auf 2 mm bis 3 mm eingestellt ist.

Da Magnetschranken in unterschiedlichen Anwendungsgebieten mit Temperaturen von bis zu 150° C betrieben werden können, ist es zweckmäßig, das aus ferromagnetischem Material bestehende Magnetleitblech zugleich als Wärmeableiter für die im Halbleiterchip entstehende Wärme vorzusehen.

Ein Verfahren zum Herstellen einer Magnetschranke der in Rede stehenden Art ist erfindungsgemäß dadurch gekennzeichnet, daß das Halbleiterchip in Mikropack-Bauform auf einen dünnen, mit fingerartigen Kontaktstrukturen versehenen Zwischenträger, z. B. bestehend aus einem Kunststoffband, gelötet wird, daß auf den mit einem vorspringenden Oberflächenteil versehenen zweiten Teil des Magnetleitblechs eine mit einer an den Vorsprung angepaßten Aussparung versehene Trägerplatte aufgebracht wird, daß sich das Halbleiterchip in der Aussparung der Trägerplatte befindet, daß die auf dem Zwischenträger und auf der Trägerplatte vorgesehenen elektrischen Verbindungen miteinander verlötet werden, daß die elektrischen Verbindungen der Trägerplatte mit äußeren Anschlußdrähten versehen werden, daß einerseits der Magnet mit dem ersten Teil des Magnetleitblechs und andererseits der mit der Trägerplatte, dem Zwischenträger und dem Halbleiterchip versehene zweite Teil des Magnetleitblechs getrennt in das Gehäuse derart eingeführt werden, daß der Magnet und das Halbleiterchip sich auf gegenüberliegenden Seiten der Ausnehmung befinden und daß schließlich der Innenraum des Gehäuses so mit einer Isoliermasse vergossen wird, daß die Anschlußstellen zwischen den äußeren Anschlußdrähten und den Anschlüssen der Trägerplatte noch von der Isoliermasse bedeckt werden.

Das Verfahren hat den Vorteil, daß das Bauelement bereits vor dem Ausgießen mit einer Vergußmasse funktionstüchtig ist, so daß in diesem Zustand verschiedene Kontrollmessungen durchgeführt werden können und fehlerhafte oder fehlerhaft montierte Bauteile bereits zu diesem Zeitpunkt erkannt und ausgewechselt werden können, so daß der Verlust an Ausschußbauelementen möglichst gering gehalten werden kann. Dieser Vorteil ist insbesondere im Hinblick auf die Verwendung des teuren Samarium-Kobalt-Magneten sehr wichtig. Außerdem lassen sich durch dieses Herstellungsverfahren bei geeigneter Vergußmasse Arbeitsgänge, nämlich das Aufkleben des Halbleiterchips sowie möglicherweise der Trägerplatte auf den zweiten Teil des Magnetleitblechs einsparen, da eine geeignete Vergußmasse einen Kleber ersetzt. Bei diesem Herstellungsverfahren kann jedoch auch das Halbleiterchip mittels eines geeigneten Klebers am Magnetleitblech bereits vor dem Plastikvergießen eigens befestigt werden. Ein weiterer Vorteil ist in der Automatisierbarkeit des Herstellungsverfahrens zu sehen.

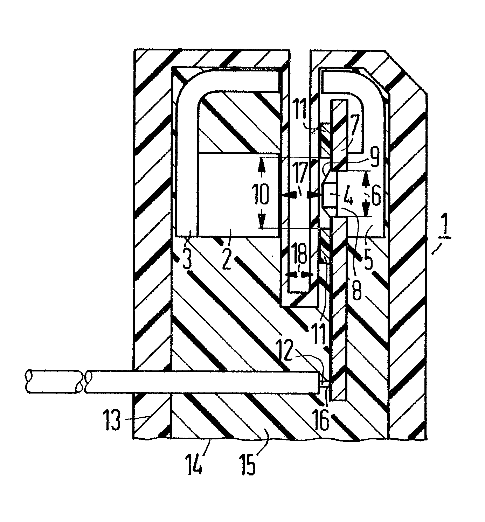

Nachfolgend wird die Erfindung anhand eines Ausführungsbeispiels und der Zeichnung näher beschrieben.

Die Figur zeigt einen Schnitt durch eine erfindungsgemäße Hall-Magnetschranke. Die Hall-Magnetschranke 1 besteht aus einem Magneten 2, z. B. bestehend aus Samarium-Kobalt, der auf einen ersten Teil 3 eines Magnetleitblechs aufgeklebt ist und aus einem mit einer integrierten Schaltung versehenen Haltleiterchip 4, das auf einem zweiten Teil 5 eines Magnetleitblechs aufgebracht ist. Der zweite Teil 5 des Magnetleitblechs ist so geformt, daß er in eine Aussparung 6 einer Trägerplatte 7 mit einem Teilstück 8 hineinragt. Auf dem Teilstück 8 des Magnetleitblechs liegt das Halbleiterchip 4 unmittelbar auf. Das Halbleiterchip 4 ist mittels fingerartiger Kontaktstrukturen 9 so mit einem Zwischenträger 11 verbunden, daß sich das Halbleiterchip 4 innerhalb einer Aussparung 10 des Zwischenträgers 11 befindet. Die fingerartigen Kontaktstrukturen 9 verbinden die elektrischen Kontakte des Chips 4 mit Kontakten des Zwischenträgers 11, die in der Ebene zwischen dem Zwischenträger 11 und der Trägerplatte 7 liegen und in der Zeichnung nicht dargestellt sind. Die elektrischen Kontakte des Zwischenträgers 11 sind wiederum mit elektrischen Kontakten der Trägerplatte 7 elektrisch leitend verbunden. Die Kontaktstrukturen der Trägerplatte 7 sind mittels äußerer Anschlußdrähte 12 versehen, die elektrisch isoliert aus dem Bauelement nach außen geleitet werden. Das Gehäuse 13 ist bis auf die Fläche 14 allseitig geschlossen. Der Gehäuseinnenraum 15 ist mit einem Isolator, z. B. einem Kunststoff, so ausgegossen, daß er Ansatzstellen 16 zwischen äußeren Anschlußdrähten 12 und Trägerplatte 7 überdeckt. Der Spalt 17 zwischen Magnet 2 und Halbleiterchip 4 beträgt ca. 1 mm bis 4 mm, insbesondere 2 mm bis 3 mm. Innerhalb des Gehäusespalts 18 dreht sich eine mit Aussparungen versehene ferromagnetische Platte, die in der Zeichnung nicht dargestellt ist, und die die erfindungsgemäße Hall-Magnetschranke öffnet oder schließt.

Zur Montage der erfindungsgemäßen Magnetschranke wird der Magnet 2 mit dem ersten Teil 3 des Magnetleitblechs, z. B. mittels Kleben, verbunden und in das Gehäuse 13 eingeführt, der zweite Teil 5 des Magnetleitblechs wird zunächst mit der Trägerplatte 7 bestückt und anschließend so mit dem Zwischenträger 11 versehen, daß das Halbleiterchip 4 auf das Teilstück 8 des zweiten Teils 5 des Magnetleitblechs aufgeklebt oder zunächst nur angedrückt wird und daß die elektrischen Anschlüsse des Zwischenträgers 11 mit zugehörigen elektrischen Anschlüssen der Trägerplatte 7 verlötet werden. Die Trägerplatte 7 wird mit äußeren Anschlußdrähten 12 versehen. Der so versehene zweite Teil 5 des Magnetleitblechs wird in das Gehäuse 13 eingeführt. Das so zusammengesteckte Bauelement ist bereits funktionstüchtig, so daß an ihm, z. B. zur Vermeidung von Ausschuß, Messungen durchgeführt werden können. Anschließend wird der Gehäuseinnenraum 15 mit einer geeigneten Vergußmasse so ausgefüllt, daß auch die Ansatzstellen 16 zwischen den äußeren Anschlußdrähten 12 und der Trägerplatte 7 von der Vergußmasse abgedeckt werden. Für den Fall, daß das Halbleiterchip 4 zunächst nur an das Teilstück 8 des Magnetleitblechs angedrückt wurde, bewirkt die Vergußmasse gleichzeitig ein Verkleben des Halbleiterchips 4 mit dem Teilstück 8.

Das Gehäuse wird z. B. aus Polybutylenterephthalat gefertigt. Der Magnet 2 kann um zu einer Miniaturisierung erfindungsgemäßer Magnetschranken aus Samarium-Kobalt gefertigt sein, ist jedoch auf dieses Material nicht beschränkt. Es kann vielmehr auch aus anderen ferromagnetischen Materialien wie z. B. Alnico bestehen. Die Magnetleitbleche 3 und 5 können aus Eisen des Typs RFE 120 bestehen. Sie sind jedoch auf dieses Material nicht beschränkt. Es kann vielmehr jedes weitere ferromagnetische Material dazu benützt werden, das gleichzeitig über eine genügende Wärmeleitfähigkeit verfügt, so daß die im Halbleiterchip 4 entstehende Wärme hinreichend abgeleitet wird. Die Trägerplatte besteht z. B. aus kupferkaschiertem Epoxid-Glashartgewebe. Sie ist jedoch auf dieses Material nicht beschränkt, sie kann auch aus Hartpapier gefertigt werden. Das Halbleiterchip kann z. B. aus Silicium gefertigt sein, ist jedoch auf dieses Material nicht beschränkt. Der Zwischenträger 11 kann aus Kunststoffband, z. B. bestehend aus Kapton gefertigt sein. Er ist jedoch auf dieses Material nicht beschränkt.

Als Vergußmasse für den Gehäuseinnenraum 15 eignet sich z. B. Epoxid-Gußmasse oder Epoxid-Kleber, jedoch können auch andere Materialien dazu verwendet werden.

In der Fertigungstechnik hat es sich als besonders günstig erwiesen, das Teilstück 8 des Magnetleitblechs mehrfach abgestuft, wie in der Zeichnung dargestellt, auszugestalten, so daß ohne aufwendige Klebungen die Trägerplatte 7 darauf aufgesteckt werden kann und die Lötstellen des Zwischenträgers 11 mit den zugehörigen Lötstellen der Trägerplatte 7 verlötet werden, so daß das Halbleiterchip 4 direkt auf dem Teilstück 8 des Magnetleitblechs aufliegt. Eine Verklebung des Halbleiterchips 4 mit dem Teilstück 8 ist vor dem Einführen der Teilstücke in das Gehäuse entbehrlich, da diese Teile beim Verguß des Gehäuseinnenraumes durch die Vergußmasse automatisch verklebt werden. Sollten technische Erfordernisse jedoch eine Verklebung vom Halbleiterchip mit dem Teilstück 8 verlangen, so kann eine diesbezügliche Verklebung auch vor dem Verguß des Gehäuseinnenraumes erfolgen.

Erfindungsgemäße Magnetschranken finden Anwendung als Positionsmelder bezüglich Translationsbewegungen sowie Rotationsbewegungen z. B. bei Werkzeugmaschinen als Endlagenschalter oder bei Bandmontagen, um das Vorrücken des Bandes geeignet zu regulieren.

Erfindungsgemäße Magnetschranken können auch bei Kombination mehrerer Magnetschranken zum Abfragen von codierten Eigenschaften benutzt werden.

Schließlich sind sie schlechthin als berührungslose Schalter anwendbar.

**Patentansprüche**

1. Magnetschranke mit einem Magneten und einem Halbleiterchip, das eine auf das vom Magneten ausgehende Magnetfeld reagierende integrierte Schaltung enthält, bei dem der Magnet und das Halbleiterchip gemeinsam in einem Gehäuse untergebracht sind, das mit einer sich zwischen dem Halbleiterchip und dem Magneten erstreckenden und der temporären Unterbrechung des Magnetfeldflusses zum Halbleiterchip durch externe Mittel dienenden spaltartigen Ausnehmung versehen ist, an deren dem Halbleiterchip gegenüberliegenden Seite der mit einer ebenen Oberfläche versehene eine Pol des Magneten angeordnet ist, während der andere Pol des Magneten an ein der externen Überbrückung des Magnetfelds auf dem Weg über das Halbleiterchip dienendes Magnetleitblech angrenzt, dadurch gekennzeichnet, daß das den an seinem dem Halbleiterchip (4) zugewandten Ende mit einem ebenen Oberflächenteil versehenen Magneten (2) tragende Magnetleitblech aus zwei Teilen besteht, wobei der mit dem Magneten (2) verbundene Teil (3) sich auf der einen Seite und der zweite Teil (5) sich auf der anderen Seite der spaltartigen Ausnehmung (17) befindet, daß dabei das Halbleiterchip (4) in einer Aussparung (10) eines — z. B. aus einem Kunststoffband bestehenden — Zwischenträgers (11) auf einem in die Aussparung (10) hineinragenden Teil (6) des zweiten Teils (5) des Magnetleitblechs (3, 5) aufliegt und seine elektrischen Anschlüsse mittels fingerartiger Kontaktstrukturen mit auf dem Zwischenträger (11) vorgesehenen elektrischen Anschlüssen verbunden sind, daß außerdem der Zwischenträger (11) seinerseits von einer aus isolierendem Material bestehenden Trägerplatte (7) gehaltert ist, die mit dem externen Anschluß der auf dem Zwischenträger (11) vorgesehenen elektrischen Anschlüsse vermittelnden leitenden Verbindungen versehen ist und daß schließlich der Gehäuseinnenraum (15) mit einer isolierenden Vergußmasse ausgegossen ist.

2. Magnetschranke nach Anspruch 1, dadurch gekennzeichnet, daß der Magnet (2) ein Samarium-Kobalt-Magnet ist.

3. Magnetschranke nach Anspruch 1 oder 2, dadurch gekennzeichnet, daß der durch die spaltartige Ausnehmung (17) zwischen dem Halbleiterchip (4) und dem ihm zugewandten ebenen Oberflächenteil des Magneten (2) bedingte Abstand auf 1 mm bis 4 mm, insbesondere auf 2 mm bis 3 mm eingestellt ist.

4. Magnetschranke nach einem der Ansprüche 1 bis 3, dadurch gekennzeichnet, daß das aus ferromagnetischem Material bestehende Magnetleitblech zugleich als Wärmeableiter für die im Halbleiterchip entstehende Wärme vorgesehen ist.

5. Verfahren zum Herstellen einer Magnetschranke nach einem der Ansprüche 1 bis 4, dadurch gekennzeichnet, daß das Halbleiterchip (4) in Mikropack-Bauform auf einen dünnen, mit fingerartigen Kontaktstrukturen versehenen Zwischenträger (11), z. B. bestehend aus einem Kunststoffband, gelötet wird, daß auf den mit einem vorspringenden Oberflächenteil (6) versehenen zweiten Teil (5) des Magnetleitblechs eine mit einer an den Vorsprung (6) angepaßten Aussparung versehene Trägerplatte (7) aufgebracht wird, daß auf die Trägerplatte (7) der Zwischenträger (11) so aufgebracht wird, daß sich das Halbleiterchip in der Aussparung der Trägerplatte (7) befindet, daß die auf dem Zwischenträger (11) und auf der Trägerplatte (7) vorgesehenen elektrischen Verbindungen miteinander verlötet werden, daß die elektrischen Verbindungen der Trägerplatte (7) mit äußeren Anschlußdrähten (12) versehen werden, daß einerseits der Magnet (2) mit dem ersten Teil (3) des Magnetleitblechs und andererseits der mit der Trägerplatte (7), dem Zwischenträger (11) und dem Halbleiterchip (4) versehene zweite Teil (5) des Magnetleitblechs getrennt in das Gehäuse derart eingeführt werden, daß der Magnet (2) und das Halbleiterchip (4) sich auf gegenüberliegenden Seiten der Ausnehmung (17) befinden und daß schließlich der Innenraum des Gehäuses so mit einer Isoliermasse vergossen wird, daß die Anschlußstellen zwischen den äußeren Anschlußdrähten (12) und den Anschlüssen der Trägerplatte (7) noch von der Isoliermasse bedeckt werden.

## Claims

1. A magnetic pass-through detector comprising a magnet and a semiconductor chip which contains an integrated circuit which reacts to the magnetic field emanating from the magnet, wherein the magnet and the semiconductor chip are accommodated in a common housing which is provided with a slit-shaped recess which extends between the semiconductor chip and the magnet and serves for the temporary interruption of the magnetic field flux to the semiconductor chip by external means, at the side of which which lies opposite to the semiconductor chip a first pole of the magnet is arranged, which pole is provided with a flat surface, whilst the other pole of the magnet adjoins a magnetic baffle plate which serves for externally bridging the magnetic field on its way across the semiconductor chip, characterised in that the magnetic baffle plate which carries the magnet (2), which is provided with a flat surface portion at its end facing towards the semiconductor chip (4), consists of two parts, the part (3) which is connected to the magnet (2) being arranged on one side of the slit-shaped recess (17) and the second part (5) on the other side thereof; that moreover, the semiconductor chip (4) is located in an opening (10) in an intermediate carrier (11) consisting for example, of a synthetic resin strip, on a portion (6) of the second part (5) of the magnetic baffle plate (3, 5) which projects into the opening (10), and its electrical contacts are connected by means of finger-like contakt structures to electrical contacts provided on the intermediate carrier (11); that, moreover, the intermediate carrier (11) is itself supported by a carrier plate (7) which consists of insulating material and which is provided with the external terminals for the electrical contacts provided on the intermediate carrier (11) and which establish electrical connections; and that finally the interior (15) of the housing is filled up with an insulating sealing compound.

2. A magnetic pass-through detector as claimed in claim 1, characterised in that the magnet (2) is a samarium-cobalt magnet.

3. A magnetic pass-through detector as claimed in claim 1 or 2, characterised in that the gap formed by the slit-shaped recess (17) between the semiconductor chip (4) and the flat part of the surface of the magnet (2) which faces towards it, is set at 1 mm to 4 mm, in particular 2 mm to 3 mm.

4. A magnetic pass-through detector as claimed in one of Claims 1 to 3, characterised in that the magnetic baffle plate which consists of ferromagnetic material simultane ously serves as a heat sink for the heat produced in the semiconductor chip.

5. A method of producing a magnetic pass-through detector as claimed in one of the claims 1 to 4, characterised in that the semiconductor chip (4) is soldered in micro-pack construction to a thin intermediate carrier (11) which is provided with finger-like contact structures and consists, for example, of a synthetic resin strip; that a carrier plate (7), provided with an opening matched to the projection (6), is fixed to the second part (5) of the magnetic baffle plate, which part is provided with a projecting surface part (6); that the intermediate carrier (11) is fixed to the carrier plate (7) in such a way that the semiconductor chip is located in the opening in the carrier plate (7); that the electrical connections, with which the intermediate carrier (11) and the carrier plate (7) are provided, are soldered to one another; that the electrical connections of the carrier plate (7) are provided with external connection wires (12); that, on the one hand, the magnet (2), together with the first part (3) of the magnetic baffle plate, and, on the other hand, the second part (5) of the magnetic baffle plate, provided with the carrier plate (7), the intermediate carrier (11) and the semiconductor chip (4), are separately introduced into the housing in such a way that the magnet (2) and the semiconductor chip (4) are arranged on opposite sides of the recess (17); and that, finally, the interior of the housing is filled up with an insulating compund in such a way that the connection points between the external terminal wires (12) and the terminals of the carrier plate (7) are still covered by the insulating compound.

## Revendications

1. Détecteur de passage magnétique comportant un aimant et une microplaquette à semiconducteurs, qui contient un circuit intégré réagissant au champ magnétique produit par l'aimant, et dans lequel l'aimant et la microplaquette à semiconducteurs sont logés en commun dans un boîtier qui est muni d'une ouverture en forme de fente qui s'étend entre la microplaquette à semiconducteurs et l'aimant et sert à interrompre temporairement le flux du champ magnétique en direction de la microplaquette à semiconducteurs grâce à des moyens extérieurs, un pôle de l'aimant, muni d'une surface plane, étant disposé sur le côté de l'évidement situé en vis-à-vis de la microplaquette à semiconducteurs, tandis que l'autre pôle de l'aimant jouxte une tôle de guidage du flux magnétique servant à réliser un shuntage extérieur du champ magnétique suivant un trajet passant par la microplaquette à semiconducteurs, caractérisé par le fait que la tôle de guidage du flux magnétique, qui porte l'aimant (2) muni d'un élément de surface plan sur son extrémité tournée vers la microplaquette à semiconducteurs (4), est constituée en deux parties, la partie (3) reliée à l'aimant (2) étant située d'un côté, et la seconde partie (5) étant située de l'autre côté de l'évidement en forme de fente (17), que la microplaquette à semiconducteurs (4) est en appui dans un évidement (10) d'un support intermédiaire (11) — constitué par exemple par une bande en matière plastique — sur un élément (6), pénétrant dans l'évidement (10), de la seconde partie (5) de la tôle de guidage du flux magnétique (3, 5) et que ses raccords électriques sont reliés au moyen de structures de contact en forme de doigts à des raccords électriques prévus sur le support intermédiaire (11) qu'en outre ce support intermédiaire (11) est soutenu pour sa part par une plaque de support (7) constituée en un matériau isolant et que est munie du raccord extérieur des liaisons conductrices constituant des raccords électriques prévus sur le support intermédiaire (11), et qu'enfin l'espace intérieur (15) du boîtier est rempli par une masse de scellement isolante.

2. Détecteur de passage magnétique suivant la revendication 1, caractérisé par le fait que l'aimant (2) est un aimant au samarium et au cobalt.

3. Détecteur de passage magnétique suivant la revendication 1 ou 2, caractérisé par le fait que la distance conditionnée par l'évidement en forme de fente (17) présent entre la microplaquette à semiconducteurs (4) et l'élément de surface plan de l'aimant (2), qui est tourné vers cette dernière, est réglée à une valeur comprise entre 1 mm et 4 mm et notamment entre 2 mm et 3 mm.

4. Détecteur de passage magnétique suivant l'une des revendications 1 à 3, caractérisé par le fait que la tôle de guidage du flux magnétique, constituée en un matériau ferromagnétique, est prévue simultanément en tant que conducteur d'évacuation de la chaleur apparaissant dans la plaquette à semiconducteurs.

5. Procédé pour fabriquer un détecteur de passage magnétique suivant l'une des revendications 1 à 4, caractérisé par le fait qu'on soude la microplaquette à semiconducteurs (4), sous la forme d'un micromodule, sur un support intermédiaire mince (11), muni de structures de contact en forme de doigts et constituée par exemple par une bande en matière plastique, qu'on dispose sur la seconde partie (5), munie d'un élément de surface saillant (6), d'une tôle de guidage du flux magnétique une plaque de support (7) munie d'un évidement adapté à la partie saillante (6), qu'on dispose le support intermédiaire (11) sur la plaque de support (7) de manière que la plaquette à semiconducteurs soit située dans l'évidement de la plaque de support (7), qu'on soude entre eux les organes de liaison électrique prévus sur le support intermédiaire (11) et sur la plaque de support (7), qu'on équipe les organes de liaison électrique de la plaque de support (7) de fils extérieurs de raccordement (12), qu'on introduit — d'une part l'aimant (2) muni de la première partie (3) de la tôle de guidage du flux magnétique et d'autre part la seconde partie (5) de la tôle de guidage du flux magnétique, équipée de la plaque de support (7), du support intermédiaire (11) et de la microplaquette à semiconducteurs (4), sèparément dans le boîtier de telle sorte que l'aimant (2) et la microplaquette à semiconducteurs (4) sont situés sur des côtés opposés de l'évidement (17), et qu'enfin on coule dans l'espace intérieur du boîtier une masse isolante de telle sorte que les points de raccordement entre les fils extérieurs de raccordement (12) et les raccords de la plaque de support (7) sont également recouverts par la masse isolante.